# EUROPÄISCHE PATENTSCHRIFT

(11) **EP 1 264 396 B1**
(45) Veröffentlichungstag und Bekanntmachung des Hinweises auf die Patenterteilung: **20.08.2003**
(21) Anmeldenummer: 01902369.6
(22) Anmeldetag: 31.01.2001
(51) Int. Cl.: H03F 1/30

(54) **SCHALTUNGSANORDNUNG ZUR ARBEITSPUNKTEINSTELLUNG EINES HOCHFREQUENZTRANSISTORS UND VERSTÄRKERSCHALTUNG**
CIRCUIT ARRANGEMENT FOR ADJUSTING THE OPERATING POINT OF A HIGH-FREQUENCY TRANSISTOR AND AN AMPLIFIER CIRCUIT
CIRCUIT PERMETTANT DE REGLER LE POINT DE FONCTIONNEMENT D'UN TRANSISTOR HAUTE FREQUENCE ET MONTAGE AMPLIFICATEUR

(30) Priorität: 06.03.2000 EP 00104820
(43) Veröffentlichungstag der Anmeldung: 11.12.2002
(73) Patentinhaber: Infineon Technologies AG, 81669 München (DE)
(72) Erfinder: SCHAFFER, Josef-Paul, 81245 - München (DE)
(74) Vertreter: Epping Hermann & Fischer
(86) Internationale Anmeldenummer: EP0101008
(87) Internationale Veröffentlichungsnummer: WO01067594

(56) Entgegenhaltungen:
- EP-A- 0 116 982
- US-A- 5 854 578
- US-A- 5 900 782
- BELLANTONI J V: "LOW DROPOUT CURRENT SOURCE PROTECTS SILICON MMICS AND TRANSISTORS" RF DESIGN,CARDIFF PUBLISHING CO, ENGLEWOOD,CO,US, Bd. 18, Nr. 8, 1. August 1995 (1995-08-01), Seiten 40,42-44, XP000523806 ISSN: 0163-321X

## Beschreibung

Die Erfindung betrifft eine Schaltungsanordnung zur Arbeitspunkteinstellung eines Hochfrequenztransistors mit Anschlüssen für Versorgungspotentiale sowie einem Anschluß für einen Meßwiderstand und eine Verstärkerschaltung mit einem Hochfrequenztransistor und einer solchen Schaltungsanordnung.

Verstärkerschaltungen für Hochfrequenzsignale weisen einen Hochfrequenztransistor auf, dem das zu verstärkende Signal an einem Steuereingang zuführbar ist und bei dem das verstärkte Signal am Lastkreis ausgekoppelt wird. Durch geeignete Gleichstromeinprägung am Steuereingang und am Laststrompfad wird der Transistor in seinem Arbeitspunkt gehalten.

Abhängig vom Versorgungsstrom haben Verstärkerschaltungen mit Hochfrequenztransistoren unterschiedliche Verstärkungseigenschaften. Es werden daher Widerstandsnetzwerke oder aktive Schaltungen angewandt, um den Arbeitspunkt des Verstärkertransistors möglichst unabhängig von dessen Fertigungstoleranzen und dessen Temperaturverhalten einzustellen.

Eine Schaltungsanordnung zur Arbeitspunkteinstellung für einen Hochfrequenztransistor ist beispielsweise die Schaltung BCR 400 von Infineon Technologies, wie beispielsweise im Datenblatt zur integrierten Schaltung BCR 400W vom 24. Februar 1999 gezeigt. Die Schaltung weist zwei Anschlüsse für eine Versorgungsspannung sowie einen Meßanschluß zum Anschluß eines Meßwiderstands sowie einen Stromausgang zum Anschluß an die Basis eines bipolaren Hochfrequenztransistors auf. Der zwischen Meßanschluß und dem positiven Pol der Versorgungsspannung geschaltete externe Meßwiderstand ist in den Kollektorstrompfad des Hochfrequenztransistors geschaltet. Der externe Meßwiderstand beträgt 100 bis 220 Ω. Der an diesem externen Widerstand anliegende Spannungsabfall beträgt cirka 600 mV. Bei Geräten mit niedriger Versorgungsspannung, insbesondere batteriebetriebenen Geräten, wird dadurch die maximale Ausgangsleistung der Verstärkerschaltung begrenzt. Durch den nicht unerheblichen Stromverbrauch am Meßwiderstand wird die Betriebszeit eines batteriebetriebenen Geräts eingeschränkt.

In der Literaturstelle Bellantoni J. V.: "Low Dropout Current Source Protects Silicon MMICs and Transistors", RF Design, Cardiff Publishing Co., Englewood CO, US, Band 18, Nr. 8, 1. August 1995, Seiten 40, 42 bis 44 ist eine HF-Verstärkerschaltung gezeigt, bei der ein Meßwiderstand mit dem Kollektroanschluß eines Hochfrequenztransistors verbunden ist und eine Regelschaltung an den Basisanschluß des Transistors gekoppelt ist. Die Regelschaltung weist einen ersten an den Meßwiderstand angeschlossenen Differenzverstärker auf sowie eine ausgangsseitig durch einen weiteren Differenzverstärker gebildete, vom ersten Differenzverstärker angesteuerte Stromquelle.

Die Aufgabe der Erfindung besteht darin, eine Schaltungsanordnung zur Arbeitspunkteinstellung eines Hochfrequenztransistors anzugeben, die bei niedriger Versorgungsspannung arbeiten kann und einen geringen Leistungsverbrauch aufweist.

Eine weitere Aufgabe besteht darin, eine Verstärkerschaltung mit einer solchen Schaltungsanordnung zur Arbeitspunkteinstellung anzugeben.

Gemäß der Erfindung wird die Aufgabe betreffend die Schaltungsanordnung zur Arbeitspunkteinstellung gelöst durch eine Schaltungsanordnung zur Arbeitspunkteinstellung eines Hochfrequenztransistors, umfassend: einen Anschluß für ein erstes Versorgungspotential und einen Anschluß für ein zweites Versorgungspotential; einen Meßanschluß, an den ein Meßwiderstand anzuschließen ist, der in Reihe mit dem Laststrompfad eines Hochfrequenztransistors geschaltet ist; einen Ausgangsanschluß, an den ein Steueranschluß des Hochfrequenztransistors zu koppeln ist; ein Differenzglied, das versorgungsspannungsmäßig mit den Anschlüssen für das erste und das zweite Versorgungspotential verbunden ist und einen ersten Signaleingang aufweist, der mit einer Referenzspannungsquelle verbunden ist, und einen zweiten Signaleingang der mit dem Meßanschluß verbunden ist; eine vom Differenzglied steuerbare Stromquelle, die mit dem Ausgangsanschluß verbunden ist; eine erste Stromspiegelschaltung mit einem Eingangspfad, der mit einer an den Anschluß für das zweite Versorgungspotential angeschlossenen Stromquelle verbunden ist, und mit einem Ausgangspfad, der über eine Steuerleitung mit dem Eingangspfad gekoppelt ist und der über einen ersten Widerstand mit dem Anschluß für das erste Versorgungspotential verbunden ist; und einen ersten Transistor, dessen Basis mit der die Pfade der ersten Stromspiegelschaltung verbindenden Steuerleitung verbunden ist, dessen Emitter über einen zweiten Widerstand mit dem Anschluß für das erste Versorgungspotential und mit dem Meßanschluß verbunden ist.

Eine Verstärkerschaltung mit einer solchen Schaltungsanordnung weist zusätzlich auf: einen Widerstand, der zwischen den Anschluß für das erste Versorgungspotential und den Meßanschluß der Schaltungsanordnung geschaltet ist und einen Hochfrequenztransistor, dessen Kollektor mit dem Meßanschluß der Schaltungsanordnung und dessen Basis mit dem Ausgangsanschluß der Schaltungsanordnung gleichstrommäßig gekoppelt sind, dessen Basis mit einem Eingangsanschluß für ein hochfrequentes Eingangssignal und dessen Kollektor mit einem Ausgangsanschluß für ein hochfrequentes Ausgangssignal gekoppelt sind.

Die Schaltungsanordnung gemäß der Erfindung weist ein von der Versorgungsspannung gespeistes Differenzglied auf, welches die Spannung am Meßwiderstand mit einer Referenzspannung vergleicht. Abhängig davon wird der Strom einer Stromquelle gesteuert, die an den Steueranschluß des Hochfrequenztransistors, beispielsweise den Basisanschluß eines bipolaren HF-Transistors anzuschließen ist. Durch die Differenzbildung ist es möglich, eine niedrige Referenzspannung vorzusehen, mit der die am externen Meßwiderstand abfallende Spannung zu vergleichen ist. In der Praxis liegt die Referenzspannung bei circa 100 mV. Die Differenz der beiden Spannungen steuert den Stromausgang der Schaltung.

In Ausgestaltung der Erfindung ist eine erste Stromspiegelschaltung vorgesehen, deren Eingangspfad von einer Stromquelle gespeist wird und in deren Ausgangspfad ein Widerstand geschaltet ist, an dem die Referenzspannung abfällt. Der Steueranschluß eines ersten Transistors ist an die die Ein- und Ausgangszweige der ersten Stromspiegelschaltung verbindende Steuerleitung angeschlossen. Laststromseitig ist der Meßwiderstand an den ersten Transistor anzuschließen. Der Laststrom des ersten Transistors wird in Abhängigkeit von der Differenz zwischen der am Meßwiderstand anliegenden Spannung und der am Widerstand im ersten Stromspiegel erzeugten Referenzspannung gesteuert. Über einen zweiten Stromspiegel wird ein in Emitterschaltung betriebener Ausgangstransistor strommäßig angesteuert. Der Laststrom dieses Ausgangstransistors oder zweiten Transistors dient zur Stromeinprägung in den Steueranschluß des Hochfrequenztransistors. Anstelle eines einzigen Ausgangstransistors eignet sich auch eine Darlington-Schaltung aus mindestens zwei Transistoren, die eine höhere Stromtreiberfähigkeit aufweist.

Die Stromquelle im Eingangszweig der ersten Stromspiegelschaltung wird auf herkömmliche Weise gebildet. Hierzu ist ein Transistor vorgesehen, dessen Laststrompfad über einen Widerstand mit Bezugspotential verbunden ist und dessen Steueranschluß über die Reihenschaltung mehrerer Dioden ebenfalls mit Bezugspotential verbunden ist. Am anderen Anschluß des Laststrompfads dieses Transistors ist ein Konstantstrom abgreifbar.

Der erste Stromspiegel ist in herkömmlicher Weise realisiert, indem Steueranschluß und Laststrompfad des Transistors im Eingangszweig gekoppelt sind. Der Steueranschluß dieses Transistors ist außerdem an den Steueranschluß des Transistors im Ausgangszweig angeschlossen.

Die Transistoren im ersten Stromspiegel sind bipolare pnp-Transistoren. Ebenfalls sind der den Differenzverstärker bildende zweite Transistor sowie der ausgangsseitige Stromquellentransistor bipolare pnp-Transistoren. Die Schaltungsanordnung kann anstelle von bipolaren Transistoren mit MOS-Transistoren realisiert werden. Dabei sind npn-Transistoren durch n-Kanal-MOS-Transistoren zu ersetzen und pnp-Transistoren durch p-Kanal-MOS-Transistoren.

Die erfindungsgemäße Schaltung hat den Vorteil, daß nur relativ wenige Bauelemente erforderlich sind. Aufgrund der geringen Komplexität paßt die Schaltung in ein kleines, kostengünstiges Standardgehäuse. Die Stromregelung der Schaltung setzt bereits bei geringer Betriebsspannung von etwa 2 Volt ein. Die Signale im Regelkreis weisen keine Phasendrehung auf, so daß die Regelung eine hohe Stabilität hat. Das Temperaturverhalten der Schaltung verhält sich umgekehrt zum Temperaturverhalten eines bipolaren Verstärkertransistors, so daß die Verstärkungsschaltung insgesamt weitgehend temperaturstabiles Verstärkungsverhalten hat.

Nachfolgend wird die Erfindung anhand des in der Zeichnung dargestellten Ausführungsbeispiels im Detail erläutert. Es zeigen:
- Figur 1: ein Blockschaltbild der Verstärkerschaltung einschließlich einer in einem integrierten Schaltkreis realisierten Schaltungsanordnung zur Arbeitspunkteinstellung und
- Figur 2: eine Realisierung der Schaltungsanordnung zur Arbeitspunkteinstellung auf Transistorebene.

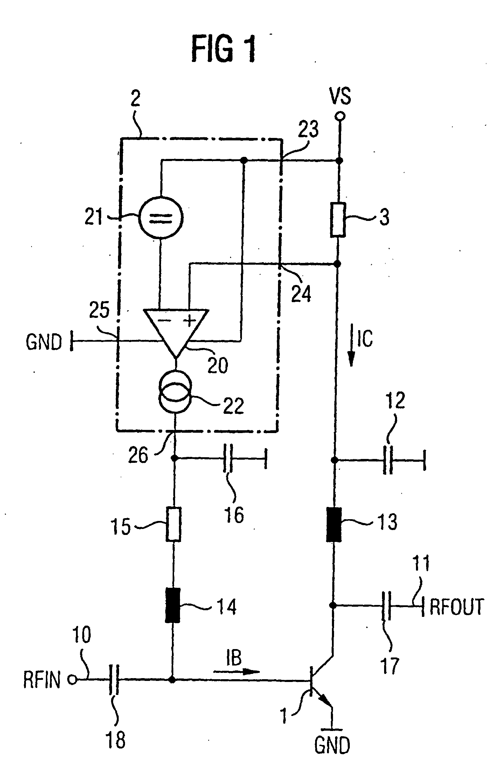

Die in Figur 1 gezeigte Verstärkerschaltung weist einen bipolaren npn-Hochfrequenztransistor 1 auf, dessen Basisanschluß mit einem Eingangsanschluß 10 für das zu verstärkende Hochfrequenzsignal RFIN verbunden ist und dessen Koliektoranschluß über einen Widerstand 3 zur Arbeitspunkteinstellung an ein positives Versorgungspotential VS angeschlossen ist. Der Emitter des Transistors 1 ist an Bezugspotential (Masse) GND angeschlossen. Das Hochfrequenzausgangssignal RFOUT ist an einem an den Kollektor des Transistors 1 angeschlossenen Ausgangsanschluß 11 abgreifbar. Eine Schaltungsanordnung zur Arbeitspunkteinstellung 2 weist einen Ausgang 26, der einen eingeprägten Strom führt, der in die Basis des Transistors 1 einkoppelt. Der Arbeitspunkt des Transistors 1 wird eingestellt, indem der Transistor 1 mit einem durch den Widerstand 3 eingestellten Kollektorstrom IC und einem hierzu angepaßten Basisstrom IB versorgt wird. Je ein den Anschlüssen 10 und 11 zugeordneter Abblockkondensator 18 bzw. 17 dient zum Abblokken der Gleichströme IB bzw. IC vom Ein- und Ausgangsanschluß. Darüber hinaus sind im Last- oder Kollektorstrompfad eine Induktivität 13 sowie in der Basisstromzuführung eine Induktivität 14 in Reihe mit einem Widerstand 15 vorgesehen sowie eine jeweilige nach Masse geschaltete Kapazität 12 bzw. 16, um das zu verstärkende Hochfrequenzsignal von der Gleichstromzuführung zu entkoppeln.

Die Schaltung zur Arbeitspunkteinstellung 2 weist einen Anschluß 23 für das positive Versorgungspotential VS auf, einen Anschluß 24, an den der Meßwiderstand 3 des Kollektorstrompfads des Verstärkertransistors 1 angeschlossen ist und einen Anschluß 25 für Bezugspotential GND. Der eingeprägte, in Abhängigkeit von der Versorgungsspannung VS, GND und dem durch den Meßwiderstand 3 fließenden Strom geregelte Basisstrom ist an einem Anschluß 26 abgreifbar. Die Schaltung 2 weist ein Differenzglied 20 auf, das von der Versorgungsspannung VS, GND gespeist wird. Der Minus-Eingang des Differenzglieds 20 ist mit einer Referenzspannungsquelle 21 verbunden, die an den Anschluß 23 für das Versorgungspotential VS angelegt ist. Der Plus-Eingang des Differenzglieds 20 ist an den Anschluß 24 geführt und greift die am Meßwiderstand 3 abfallende Spannung ab. In Abhängigkeit von der vom Differenzglied 20 ermittelnden Spannungsdifferenz wird eine Stromquelle 22 gesteuert, welche den Basisstrom IB am Anschluß 26 bereitstellt.

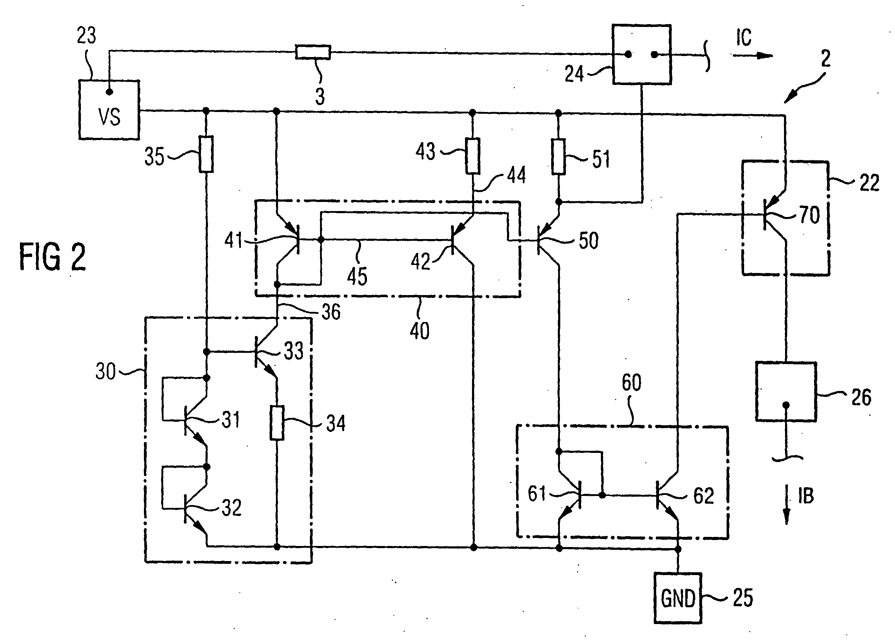

Die Ausführung der Schaltungsanordnung 2 ist in Figur 2 im Detail dargestellt. Entsprechende Elemente sind mit gleichen Bezugszeichen versehen. Die Schaltung weist eine Stromquelle 30 auf, die an den Bezugspotentialanschluß 25 angeschlossen ist und ausgangsseitig an einem Anschluß 26 einen Konstantstrom bereitstellt. Die Stromquelle umfaßt einen Bipolartransistor 33, dessen Emitter über einen Widerstand 34 mit dem Bezugspotentialanschluß 25 verbunden ist. Die Basis des Transistors 33 ist über zwei in Reihe geschaltete Bipolardioden 31, 32 mit dem Bezugspotentialanschluß 25 verbunden. Über einen Widerstand 35 wird der Reihenschaltung der Dioden 31, 32 ein Strom vom Anschluß 23 für das positive Versorgungspotential VS zugeführt. Der am Anschluß 36 der Stromquelle 30 gelieferte Konstantstrom wird in den Eingangszweig einer Stromspiegelschaltung 40 eingekoppelt. Die Stromspiegelschaltung 40 umfaßt eingangsseitig einen Bipolartransistor 41, dessen Kollektor und Basis miteinander verbunden sind. Der Kollektoranschluß des Transistors 41 ist mit der Stromquelle 30 verbunden, der Emitteranschluß mit dem Anschluß 23 für das positive Versorgungspotential VS. Der Ausgangszweig des Stromspiegels 40 enthält einen Bipolartransistor 42, dessen Kollektor direkt an den Bezugspotentialanschluß 25 angeschlossen ist und dessen Emitter über einen Widerstand 43 an den Versorgungspotentialanschluß 23 angeschlossen ist. Der Transistor 42 kann im Vergleich zum Transistor 41 einen höheren Strom führen. Er ist als Multiemittertransistor ausgeführt oder als Parallelschaltung mehrerer Transistoren. Basisseitig ist der Transistor 42 mit der Basis des Transistors 41 verbunden. Der von der Stromquelle 36 gelieferte Konstantstrom wird über den Stromspiegel 40 entsprechend verstärkt an den Widerstand 43 bereitgestellt, so daß sich am stromspiegelseitigen Anschluß 44 des Widerstands 43 eine auf das positive Versorgungspotential VS bezogene Konstantspannung einstellt.

Ein weiterer Bipolartransistor 50 weist emitterseitig einen Widerstand 51 auf, der an den Versorgungspotentialanschluß 23 angeschlossen ist. Die Basis des Transistors 50 ist an die Verbindungsleitung 45 zwischen den die Eingangs- und Ausgangszweige bildenden Transistoren 41, 42 des Stromspiegels 40 geschaltet, also die Verbindungsleitung der Basisanschlüsse der Transistoren 41, 42. Der Emitter des Transistors 50 ist außerdem an den Anschluß 24 angeschlossen, an welchem der Meßwiderstand 3 für den Kollektorstrom des Hochfrequenzverstärkertransistors 1 liegt. Der Transistor 50 wird also in Basisschaltung betrieben. In Abhängigkeit von dem durch den Meßwiderstand 3 fließenden Strom wird die Basis-Emitter-Spannung des Transistors 50 und somit dessen Kollektorstrom beeinflußt. Im einzelnen wird die am Meßwiderstand 3 abfallende Spannung mit der am Schaltungsknoten 44 oder Widerstand 43 anliegenden Konstantspannung verglichen und in Abhängigkeit von der Spannungsdifferenz zwischen der am Widerstand 3 abfallenden Spannung und der am Widerstand 43 anliegenden Konstantspannung der Kollektorstrom des Bipolartransistors 50 eingestellt. Der Kollektorstrom des Transistors 50 wird über einen an den Bezugspotentialanschluß 25 angeschlossene Stromspiegel 60 gespiegelt und dem Basisanschluß eines die Stromquelle 22 bildenden Bipolartransistors 70 zugeführt. Der Stromspiegel 60 umfaßt eingangsseitig einen Transistor 61 mit gekoppelten Kollektor- und Basisanschlüssen sowie ausgangsseitig einen Transistor 62, dessen Basis mit der Basis des Transistors 61 verbunden ist. Der Kollektor des Transistors 62 ist mit der Basis des Transistors 70 verbunden. Günstigerweise wird der Strom zwischen Eingangs- und Ausgangspfad des Stromspiegels 60 verstärkt, beispielsweise verdoppelt, indem der Transistor 62 als Doppelemittertransistor ausgeführt ist. Der Emitter des Transistors 70 liegt auf dem Potential VS, der Transistor 70 wird also in Emitterschaltung betrieben.

Alternativ zu einem einzigen Transistor 70 kann auch eine (nicht dargestellte) Darlington-Schaltung aus zwei oder mehreren Transistoren die Stromquelle 22 bilden. Im Vergleich zu einem einzigen Transistor weist die Darlington-Schaltung eine höhere Stromtreiberfähigkeit auf. Bei einer aus zwei pnp-Transistoren gebildeten Darlington-Schaltung ist der Emitteranschluß des ersten Darlington-Transistors mit dem Anschluß 23 verbunden. Der Emitter des zweiten Darlington-Transistors ist mit der Basis des ersten Darlington-Transistors verbunden. Die Basis des zweiten Darlington-Transistors ist mit dem Ausgangszweig des Stromspiegels 60 verbunden. Die Kollektoranschlüsse der Darlington-Transistoren sind miteinander verbunden und sind an den Ausgangsanschluß 26 angeschlossen.

Durch die Schaltungsanordnung zur Arbeitspunkteinstellung für den Hochfrequenztransistor 1 wird also in Abhängigkeit von einem aufgrund der Stromquelle 30 bereitgestellten Konstantstrom am Widerstand 43 eine Konstantspannung erzeugt, und weiterhin durch Differenzbildung mittels der an ihren Basisanschlüssen gekoppelten Transistoren 42, 50 mit der am Transistor 50 eingekoppelten Meßspannung ein von dieser Differenz abhängiger Kollektorstrom des Transistors 50 erzeugt, der nach Spiegelung und Verstärkung als Ausgangsstrom am Anschluß 26 bereitsteht.

Die Transistoren 31, 32, 33 der Stromquelle 30 sowie die Transistoren 61, 62 des Stromspiegels 60 sind npn-Bipolartransistoren. Die Transistoren 41, 42 des Stromspiegels 40 sowie der Transistor 50 und der Stromquellentransistor 22 sind pnp-Bipolartransistoren. Der Laststrompfad eines jeden der npn- und pnp-Transistoren ist dessen Kollektor-Emitter-Strompfad. Der Steueranschluß eines jeden Transistors ist dessen Basisanschluß. Die beschriebene Ausführung ermöglicht einen Betrieb bei geringer Spannung. Bereits bei einer Betriebsspannung VS, GND von 2 V setzt die Regelung ein. Die Schaltung weist eine überschaubare Anzahl von Transistoren und Widerständen auf, die bei integrierter Realisierung einen nur geringen Bedarf an Siliziumfläche erfordern. Die monolithisch integrierte Schaltung kann ohne weiteres in einem kleinen standardgemäßen 4-Pin-Gehäuse unterbracht werden.

Anstelle der Realisierung in einer bipolaren Halbleitertechnologie wie gezeigt kann die Schaltung auch in MOS-Technologie realisiert werden. Anstelle der gezeigten Bipolartransistoren 31, 32, 33, 61, 62 können n-Kanal-MOS-Transistoren verwendet werden. Anstelle der gezeigten pnp-Bipolartransistoren 41, 42, 50, 22 können p-Kanal-MOS-Transistoren verwendet werden. Die Laststrompfade der MOS-Transistoren sind deren Drain-Source-Strecken. Die Steuerelektroden der MOS-Transistoren sind deren Gateelektroden.

Bekanntlich ist die an der Basis-Emitter-Strecke eines Bipolartransistors abfallende Spannung temperaturabhängig. Mit steigender Temperatur nimmt die Basis-Emitter-Spannung ab. Für ansteigende Temperatur weist die an der Basis-Emitter-Strecke des Transistors 50 abfallende Spannungsdifferenz einen negativen Koeffizienten auf, so daß der am Anschluß 26 bereitgestellte Basisstrom ebenfalls einen negativen Temperaturkoeffizienten hat. Dadurch wird der Kollektorstrom des bipolaren Hochfrequenzverstärkertransistors 1 abgeregelt. Das Temperaturverhalten der Schaltung 2 verläuft entgegengesetzt zum Temperaturverhalten des Transistors 1, so daß der Arbeitspunkt des Transistors 1 temperaturstabil bleibt.

## Patentansprüche

1. Schaltungsanordnung zur Arbeitspunkteinstellung eines Hochfrequenztransistors, umfassend:
- einen Anschluß (23) für ein erstes Versorgungspotential (VS) und einen Anschluß (25) für ein zweites Versorgungspotential (GND) ;
- einen Meßanschluß (24), an den ein Meßwiderstand (3) anzuschließen ist, der in Reihe mit dem Laststrompfad eines Hochfrequenztransistors (1) geschaltet ist;
- einen Ausgangsanschluß (26), an den ein Steueranschluß des Hochfrequenztransistors (1) zu koppeln ist;
- ein Differenzglied, das versorgungsspannungsmäßig mit den Anschlüssen (23, 25) für das erste und das zweite Versorgungspotential verbunden ist und einen ersten Signaleingang (-) aufweist, der mit einer Referenzspannungsquelle (21) verbunden ist, und einen zweiten Signaleingang (+) der mit dem Meßanschluß (24) verbunden ist;
- und eine vom Differenzglied (20) steuerbare Stromquelle (22), die mit dem Ausgangsanschluß (26) verbunden ist;
**gekennzeichnet durch**
- eine erste Stromspiegelschaltung (40) mit einem Eingangspfad (41), der mit einer an den Anschluß (25) für das zweite Versorgungspotential angeschlossenen Stromquelle (30) verbunden ist, und mit einem Ausgangspfad (42), der über eine Steuerleitung (45) mit dem Eingangspfad (41) gekoppelt ist und der über einen ersten Widerstand (43) mit dem Anschluß (23) für das erste Versorgungspotential verbunden ist; und
- einen ersten Transistor (50), dessen Basis mit der die Pfade der ersten Stromspiegelschaltung (40) verbindenden Steuerleitung (45) verbunden ist, dessen Emitter über einen zweiten Widerstand (51) mit dem Anschluß (23) für das erste Versorgungspotential (VS) und mit dem Meßanschluß (24) verbunden ist.

2. Schaltungsanordnung nach Anspruch 1,
**gekennzeichnet durch**
einen zweiten Transistor (70) in Emitterschaltung, dessen Basis über einen zweiten Stromspiegel (60) mit dem ersten Transistor (50) verbunden ist und dessen Kollektor mit dem Ausgangsanschluß (26) verbunden ist.

3. Schaltungsanordnung nach Anspruch 1 oder 2,
**dadurch gekennzeichnet,daß**
die Stromquelle (30) den Laststrompfad eines Transistors (33) enthält, daß der Laststrompfad einerseits mit dem Eingangszweig (41) des ersten Stromspiegels (40) verbunden ist und andererseits über einen Widerstand (34) mit dem Anschluß (25) für das zweite Versorgungspotential (GND) und daß der Steueranschluß dieses Transistors (33) über eine Reihenschaltung aus mindestens zwei Dioden (31, 32) mit dem Anschluß (25) für das zweite Versorgungspotential verbunden ist.

4. Schaltungsanordnung nach Anspruch 1 oder 2,
**dadurch gekennzeichnet,daß**
der Eingangszweig (41) des ersten Stromspiegels (40) die Laststrecke eines Transistors aufweist, dessen Steueranschluß mit seiner Laststrecke gekoppelt ist, und daß der Ausgangszweig des ersten Stromspiegels (40) die Laststrecke eines weiteren Transistors (42) aufweist, dessen Steueranschluß mit dem Steueranschluß des Transistors (41) des Eingangszweigs gekoppelt ist.

5. Schaltungsanordnung nach Anspruch 4,
**dadurch gekennzeichnet,daß**
der zweite Stromspiegel (60) einen ersten Transistor (61) aufweist, dessen Laststrompfad mit dem Laststrompfad des zweiten Transistors (50) gekoppelt ist und dessen Steueran schluß mit seinem Laststrompfad gekoppelt ist, und einen zweiten Transistor (62), dessen Laststrompfad mit dem Steueranschluß des zweiten Transistors (70) verbunden ist, und daß die Steueranschlüsse der Transistoren (61, 62) des zweiten Stromspiegels (60) miteinander gekoppelt sind.

6. Schaltungsanordnung nach Anspruch 4,
**dadurch gekennzeichnet,daß**
die Transistoren (41, 42) des ersten Stromspiegels (40) pnp-Transistoren oder n-Kanal-MOS-Transistoren sind.

7. Schaltungsanordnung nach Anspruch 2,
**dadurch gekennzeichnet,daß**
der erste und der zweite Transistor (50, 70) pnp-Transistoren oder p-Kanal-MOS-Transistoren sind.

8. Schaltungsanordnung nach Anspruch 1,
**gekennzeichnet durch**
Ausführung der Stromquelle (22) als eine Darlington-Schaltung mit mindestens zwei Transistoren.

9. Verstärkerschaltung mit einer Schaltungsanordnung nach einem der Ansprüche 1 bis 8,
**gekennzeichnet durch**
einen Widerstand (3), der zwischen den Anschluß (23) für das erste Versorgungspotential (VS) und den Meßanschluß (24) der Schaltungsanordnung geschaltet ist und einen Hochfrequenztransistor (1), dessen Kollektor mit dem Meßanschluß (24) der Schaltungsanordnung und dessen Basis mit dem Ausgangsanschluß (26) der Schaltungsanordnung gleichstrommäßig gekoppelt sind, dessen Basis mit einem Eingangsanschluß (10) für ein hochfrequentes Eingangssignal (RFIN) und dessen Kollektor mit einem Ausgangsanschluß (11) für ein hochfrequentes Ausgangssignal (RFOUT) gekoppelt sind.

## Claims

1. Circuit arrangement for setting the operating point of a radiofrequency transistor comprising:
- a terminal (23) for a first supply potential (VS) and a terminal (25) for a second supply potential (GND);
- a measurement terminal (24), to which is to be connected a measuring resistor (3) connected in series with the load current path of a radiofrequency transistor (1);
- an output terminal (26), to which a control terminal of the radiofrequency transistor (1) is to be coupled;
- a differential element, which, in terms of supply voltage, is connected to the terminals (23, 25) for the first and second supply potentials and has a first signal input (-), which is connected to a reference voltage source (21), and a second signal input (+) which is connected to the measurement terminal (24);
- and a current source (22) which can be controlled by the differential element (20) and is connected to the output terminal (26);
**characterized by**
- a first current mirror circuit (40) having an input path (41), which is connected to a current source (30) connected to the terminal (25) for the second supply potential, and having an output path (42), which is coupled to the input path (41) via a control line (45) and is connected to the terminal (23) for the first supply potential via a first resistor (43), and by a first transistor (50), whose base is connected to the control line (45) connecting the paths of the first current mirror circuit (40), and whose emitter is connected via a second resistor (51) to the terminal (23) for the first supply potential (VS) and to the measurement terminal (24).

2. Circuit arrangement according to Claim 1,
**characterized by**
a second transistor (70) in common-emitter circuit whose base is connected to the first transistor (50) via a second current mirror (60) and whose collector is connected to the output terminal (26).

3. Circuit arrangement according to Claim 1 or 2,
**characterized in that**
the current source (30) contains the load current path of a transistor (33), **in that** the load current path is connected, at one end, to the input branch (41) of the first current mirror (40) and, at the other end, via a resistor (34) to the terminal (25) for the second supply potential (GND), and **in that** the control terminal of this transistor (33) is connected to the terminal (25) for the second supply potential via a series circuit comprising at least two diodes (31, 32).

4. Circuit arrangement according to Claim 1 or 2,
**characterized in that**
the input branch (41) of the first current mirror (40) has the load path of a transistor whose control terminal is coupled to its load path, and **in that** the output branch of the first current mirror (40) has the load path of a further transistor (42), whose control terminal is coupled to the control terminal of the transistor (41) of the input branch.

5. Circuit arrangement according to Claim 4,
**characterized in that** the second current mirror (60) has a first transistor (61), whose load current path is coupled to the load current path of the second transistor (50) and whose control terminal is coupled to its load current path, and a second transistor (62), whose load current path is connected to the control terminal of the second transistor (70), and **in that** the control terminals of the transistors (61, 62) of the second current mirror (60) are coupled to one another.

6. Circuit arrangement according to Claim 4,
**characterized in that**
the transistors (41, 42) of the first current mirror (40) are pnp transistors or n-channel MOS transistors.

7. Circuit arrangement according to Claim 2,
**characterized in that**
the first and second transistors (50, 70) are pnp transistors or p-channel MOS transistors.

8. Circuit arrangement according to Claim 1,
**characterized by**
embodiment of the current source (22) as a Darlington circuit with at least two transistors.

9. Amplifier circuit having a circuit arrangement according to one of Claims 1 to 8,
**characterized by**
a resistor (3), which is connected between the terminal (23) for the first supply potential (VS) and the measurement terminal (24) of the circuit arrangement, and a radiofrequency transistor (1), whose collector is DC-coupled to the measurement terminal (24) of the circuit arrangement and whose base is DC-coupled to the output terminal (26) of the circuit arrangement, whose base is coupled to an input terminal (10) for a radiofrequency input signal (RFIN) and whose collector is coupled to an output terminal (11) for a radio frequency output signal (RFOUT).

## Revendications

1. Circuit de réglage du point de fonctionnement d'un transistor haute fréquence, comprenant :
- une borne (23) pour un premier potentiel (VS) d'alimentation et une borne (25) pour un deuxième potentiel (GND) d'alimentation ;
- une borne (24) de mesure, à laquelle est raccordée une résistance (3) de mesure, qui est montée en série avec le trajet du courant de charge d'un transistor (1) haute fréquence ;
- une borne (26) de sortie, à laquelle est couplée une borne de commande du transistor (1) haute fréquence ;
- un élément différentiateur, qui est relié du point de vue de la tension d'alimentation aux bornes (23, 25) pour le premier et le deuxième potentiels d'alimentation et qui a une première entrée (-) de signal qui est reliée à une source (21) de tension de référence et une deuxième entrée (+) de signal qui est reliée à la borne (24) de mesure ;
- et une source (22) de courant qui peut être commandée par l'élément (20) différentiateur et qui est reliée à la borne (26) de sortie ;
**caractérisé par**
- un premier circuit (40) à miroir de courant ayant un trajet (41) d'entrée, qui est relié à une source (30) de courant raccordée à la borne (25) pour le deuxième potentiel d'alimentation et à un trajet (42) de sortie qui est couplé au trajet (41) d'entrée par un conducteur (45) de commande et qui est relié par une première résistance (43) à la borne (23) pour le premier potentiel d'alimentation ; et
- un premier transistor (50), dont la base est reliée au conducteur (45) de commande reliant les trajets du premier circuit (40) à miroir de courant, et dont l'émetteur est relié par une deuxième résistance (51) à la borne (23) pour le premier potentiel (VS) d'alimentation et à la borne (24) de mesure.

2. Circuit suivant la revendication 1,
**caractérisé**
**par** un deuxième transistor (70) dans le circuit d'émetteur, dont la base est reliée par un deuxième miroir (60) de courant au premier transistor (50) et dont le collecteur est relié à la borne (26) de sortie.

3. Circuit suivant la revendication 1 ou 2,
**caractérisé**
**en ce que** la source (30) de courant comporte le trajet du courant de charge d'un transistor (33), en ce que le trajet de courant de charge est relié, d'une part, à la branche (41) d'entrée du premier miroir (40) de courant et, d'autre part, par une résistance (34) à la borne (25) pour le deuxième potentiel (GND) d'alimentation et en ce que la borne de commande de ce transistor (33) est reliée par un circuit série constitué d'au moins deux diodes (31, 32) à la borne (25) pour le deuxième potentiel d'alimentation.

4. Circuit suivant la revendication 1 ou 2,
**caractérisé**
**en ce que** la branche (41) d'entrée du premier miroir (40) de courant comporte la section de charge d'un transistor, dont la borne de commande est couplée à sa section de charge et en ce que la branche de sortie du premier miroir (40) de courant comporte la section de charge d'un autre transistor (42), dont la borne de commande est couplée à la borne de commande du transistor (41) de la branche d'entrée.

5. Circuit suivant la revendication 4,
**caractérisé**
**en ce que** le deuxième miroir (60) de courant comporte un premier transistor (61), dont le trajet du courant de charge est couplé au trajet du courant de charge du deuxième transistor (50) et dont la borne de commande est couplée à son trajet de courant de charge, et un deuxième transistor (62), dont le trajet de courant de charge est relié à la borne de commande du deuxième transistor (70) et en ce que les bornes de commande des transistors (61, 62) du deuxième miroir (60) de courant sont couplées entre elles.

6. Circuit suivant la revendication 4,
**caractérisé**
**en ce que** les transistors (41, 42) du premier miroir (40) de courant sont des transistors pnp ou des transistors MOS à canal n.

7. Circuit suivant la revendication 2,
**caractérisé**
**en ce que** le premier et le deuxième transistor (50, 70) sont des transistors pnp ou des transistors MOS à canal p.

8. Circuit suivant la revendication 1,
**caractérisé**
**par** une réalisation de la source (22) de courant sous la forme d'un montage Darlington ayant au moins deux transistors.

9. Montage amplificateur ayant un circuit suivant l'une des revendications 1 à 8,
**caractérisé par** une résistance (3) qui est montée entre la borne (23) pour le potentiel (VS) d'alimentation et la borne (24) de mesure du circuit et un transistor (1) haute fréquence, dont le collecteur est couplé en courant continu à la home (24) de mesure du circuit et dont la base est couplée en courant continu à la home (26) de sortie du circuit, dont la base est couplée à une borne (10) d'entrée pour un signal (RFIN) d'entrée haute fréquence et dont le collecteur est couplé à une borne (11) de sortie pour un signal (RFOUT) de sortie haute fréquence.
